# EUROPÄISCHE PATENTSCHRIFT

(11) **EP 0 338 259 B1**
(45) Veröffentlichungstag und Bekanntmachung des Hinweises auf die Patenterteilung: **06.07.1994**
(21) Anmeldenummer: 89104912.4
(22) Anmeldetag: 18.03.1989
(51) Int. Cl.: H05K 7/14

(54) **Modul für eine aus mehreren auf einem Träger nebeneinander angeordneten Modulen bestehenden Steuerung**
Control unit formed of several modules arranged side-by-side on a support
Unité de commande composée de plusieurs modules arrangés les uns à côté des autres sur un support

(30) Priorität: 20.04.1988 DE 3813888
(43) Veröffentlichungstag der Anmeldung: 25.10.1989
(73) Patentinhaber: SCHLEICHER ELECTRONIC GMBH & CO. KG, D-85764 Oberschleissheim (DE)
(72) Erfinder: Schropp, Klaus, D-8961 Sulzberg-Graben (DE); Gügel, Gerhard, D-8918 Diessen a.A. (DE)
(74) Vertreter: Pfenning, Meinig & Partner

(56) Entgegenhaltungen:
- EP-A- 247 988
- EP-A- 0 236 711
- CH-A- 400 288
- DE-B- 1 271 239
- US-A- 4 152 750

## Beschreibung

Die Erfindung betrifft eine Baugruppenanordnung für eine aus mehreren auf einem Träger nebeneinander angeordneten Baugruppen bestehende Steuerung, insbesondere zur Aufnahme von analogen Ein- und/oder Ausgängen nach dem Oberbegriff des Hauptanspruchs.

Für die Steuerung von Handhabungsgeräten, numerischen Maschinen oder dergleichen sind Steuerungen vorgesehen, die aus mehreren als Flachbaugruppe ausgebildeten Baugruppen bestehen, wobei die Baugruppen auf einen Träger aufgenommen werden, beispielsweise eingeschwenkt werden. Dabei weisen die Baugruppen und der Träger Steckleisten auf, die ineinander steckbar sind und so eine elektrische Verbindung herstellen. Die Baugruppenanordnungen, die je nach Funktion und Steuervorgaben speziell ausgebildet sein können und deren Anzahl ebenfalls variieren kann, weisen in der Regel ein flaches rechteckförmiges Gehäuse auf, das ein oder mehrere mit Bauelementen bestückte Leiterplatten aufnimmt, wobei in der Frontseite Anzeigeelemente, Schalter, Stecker oder dergleichen angeordnet sein können. Für die Steuerung ist auch ein Eingang-/Ausgang-Modul notwendig, wobei in der Frontseite neben möglichen Anzeigeelementen Steckverbindungen vorgesehen sind. Üblicherweise sind diese Steckverbindungen mit einer oder mehreren Klappen oder Deckeln abgedeckt, wobei hinter den Klappen Kabelkanäle für die mit dem Stecker oder Steckleiste verbundenen Leitungen gebildet werden.

So ist in der EP 247 988 eine Anordnung für eine aus mehreren Baugruppen bestehende Steuerung beschrieben. Diese sind mit Führungen, zur Aufnahme von Modulen in Form von Unterbaugruppen (insbesondere zur Wandlung elektrischer Signale in optische Signale), in einem Gehäuse versehen. Diesen Modulen ist jeweils ein Eingang oder Ausgang zugeordnet. Dabei sind sie von der Frontseite in das Gehäuse einschiebbar. Außerdem ist im Gehäuse eine Grundplatte vorhanden, auf der für alle Eingänge und/oder Ausgänge eine gemeinsam verwendbare Schaltung aufgenommen ist. Ferner sind auf der Grundplatte und an den einzelnen Modulen vorhandenen Schaltungen (in Form von Leiterplatten) Steckverbindungen angeordnet, die im eingeschobenen Zustand der Module diese mit der Schaltung auf der Grundplatte verbinden.

Weiterhin geht aus der US 4 152 750 ein Ein-/Ausgabe-Interface Gehäuse hervor, in das mehrere Ein-/Ausgabe-Interface Module und ein Koppelmodul einschiebbar sind. Die einzelnen Module (Unterbaugruppen) sind ebenfalls mittels Steckverbindungen mit einer Leiterplatte am Boden Gehäuses verbindbar. Die Leiterplatten der Module sind in einem eigenen geformten Plastikgehäuse aufgenommen. Die Führungsfunktion wird durch die Verbindungselemente zwischen den auf der Grundplatte und der an dem jeweiligen Modul befindlichen Steckverbindung übernommen. Gehalten werden die einzelnen Module mit Schrauben, die an den Seiten der einzelnen Module in dort befindlichen Ansätzen aufgenommen sind und im Gehäuse in dort definiert angeordnete Montageleisten einschraubbar sind.

Aus der CH 400 288 ist ein zweiteiliges Gehäuse für Wandbefestigung zur Aufnahme von Geräten oder Baugruppen insbesondere von elektronischen Steuer- und Regelanlagen bekannt. Dabei können in dieses Gehäuse einschiebbare Baugruppen aufgenommen werden, die in Nuten geführt werden.

Der Erfindung liegt die Aufgabe zugrunde, eine Baugruppenanordnung für eine Steuerung, insbesondere ein Ein-/Ausgangsmodul zu schaffen, das eine große Anzahl von unterschiedlichen Ein- und/oder Ausgängen aufnehmen kann und bei dem die Auswechslung von Ein- und/oder Ausgängen vereinfacht werden und schneller vor sich gehen kann.

Diese Aufgabe wird erfindungsgemäß durch die kennzeichnenden Merkmale des Hauptanspruches in Verbindung mit den Merkmalen des Oberbegriffes gelöst.

Dadurch, daß in dem Gehäuse mehrere übereinander angeordnete Führungen zur Aufnahme von Schubblöcken vorgesehen sind, wobei den Schubblöcken jeweils ein Ein- oder Ausgang zugeordnet sind, und daß die Schubblöcke von der Frontseite her in die Führungen einschiebbar sind, können die jeweiligen Ein- oder Ausgänge durch einfaches Herausnehmen eines Schubblockes und Einsetzen eines anderen Schubblockes schnell ausgetauscht werden. Außerdem können durch die Schubanordnung eine größere Anzahl von Ein- oder Ausgängen in einer Baugruppe aufgenommen werden.

Ein Ausführungsbeispiel der Erfindung ist in der Zeichnung dargestellt und wird in der nachfolgenden Beschreibung näher erläutert. Es zeigen:
- Fig. 1: eine Ansicht der Baugruppenanordnung von der Vorderseite, wobei zwei Schubblöcke nicht in die Führungen eingeschoben sind, und
- Fig. 2: die Ansicht des Gehäuses eines Schubblocks.

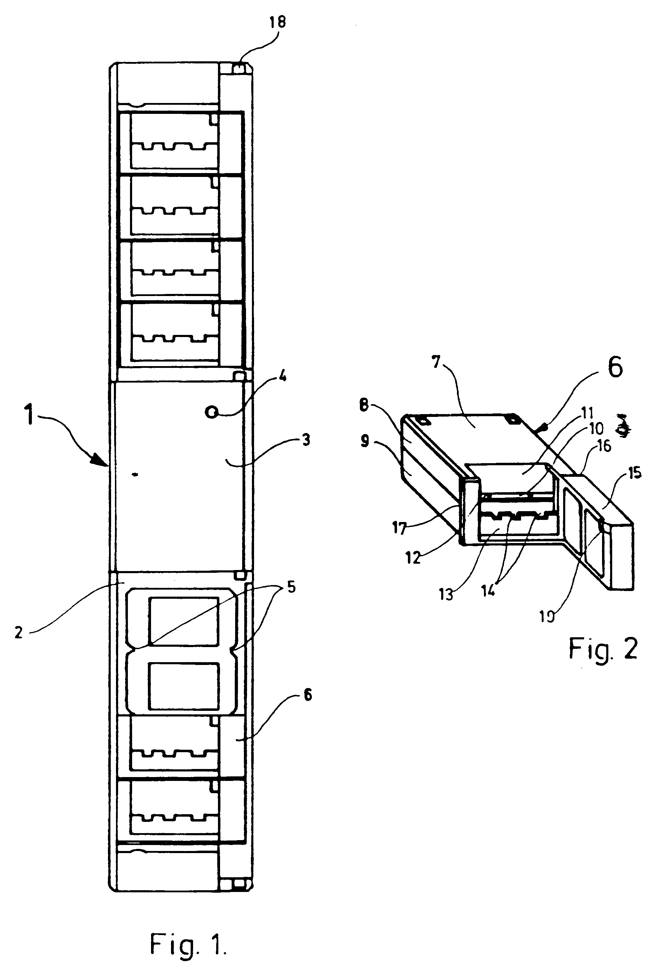

In Fig. 1 ist eine analoge Eingangs-/Ausgangs- Baugruppenanordnung von vorn gesehen dargestellt. Diese weist ein flaches Gehäuse 2 auf, das auf der Rückseite mit einer Steckleiste versehen ist, die mit einer entsprechenden Steckanordnung auf einem Träger verbindbar ist und die elektrische Versorgung für die Baugruppenanordnung bildet, ausgestattet. Die Frontseite der Baugruppenanordnung 1 weist ein abgeschlossenes Mittelteil 3 auf, das Anzeigeelemente beispielsweise Leuchtdioden 4 trägt.

Oberhalb und unterhalb dieses Mittelteils 3 weist das Gehäuse übereinander angeordnete Führungen 5 auf, die in einer gewissen Tiefe des Gehäuses 2 enden. Auf die Führungen 5 sind Schubblöcke 6, wie in Fig. 2 dargestellt, geschoben, wobei jeweils oberhalb und unterhalb des Mittelblocks 3 vier Schubblöcke 6 aufgenommen werden können.

Im hinteren Teil der Baugruppenanordnung 1 ist eine nicht dargestellte Leiterplatte angeordnet, die eine Schaltung trägt, wobei diese Schaltung Bestandteil der Ein- und/oder Ausgangsschaltungen ist. Die Ein- und Ausgangsschaltungen sind derart aufgeteilt, daß der Schaltungsteil, der für alle Ein- und/oder Ausgangsteile gemeinsam verwendbar sind, auf der einen Leiterplatte im hinteren Teil der Baugruppenanordnung 1 vorgesehen ist, während die für jeden Ein- und/oder Ausgang spezifische Schaltung jeweils einem Schubblock 6 zugeordnet ist. Dazu sind in einem Gehäuse 7 jedes Schubblocks 6 jeweils eine Leiterplatte mit der spezifischen Schaltung angeordnet. Die Leiterplatten mit den spezifischen Schaltungen und die Leiterplatte mit der gemeinsamen Schaltung weisen an entsprechenden Stellen Leisten von Steckverbindungen auf, wobei diese Steckverbindungen in Kontakt treten, wenn die Schubblöcke 6 auf die Führungen 5 aufgeschoben werden.

Das Gehäuse 7 jedes Schubblocks 6 besteht aus zwei Teilen 8, 9, die durch entsprechende an den hinteren Enden der Gehäuseteile 8, 9 vorgesehene Rastnasen miteinander verrastbar sind. Das Gehäuse 7 des Schubblocks 6 weist eine durch einen Schlitz 10 unterbrochene vordere Abschlußwand 11 auf und eine entsprechende Wand ist auf der Rückseite des Gehäuses vorgesehen. Die Schlitze 10 dienen als Durchgriff für die Leiterplatte mit der spezifischen Schaltung, wobei in den Schlitz 10 an der Vorderwand 11 bzw. Rückwand angeformte Arretiernasen 12 hineinragen, die in entsprechende Vertiefungen in der Leiterplatte eingreifen und so die Leiterplatte festlegen. Vor der vorderen Wand 11 ist eine Stützwand 13 vorgesehen, die Ausnehmungen 14 aufweist, wobei die Leiterplatte mit der spezifischen Schaltung auf der Stützwand 14 aufliegt bzw. mit dieser abschließt. An diesem vorderen Ende der Leiterplatte mit der spezifischen Schaltung ist ebenfalls ein Teil einer Steckverbindung angeordnet, wobei der andere Teil der Steckverbindung anwenderseitig mit entsprechenden Leitungen verbunden ist. Die Stützwand 13 mit den Ausnehmungen 14 dient ebenfalls zur Festlegung und Arretierung der Steckverbindung.

An dem Gehäuse 7 der Schubblock 6 ist ein Griff 15 seitlich angeformt, der sich in Schubrichtung nach vorn erstreckt. Der Griff 15 dient zum einfachen Einschieben bzw. Herausziehen des Schubblocks 6. Der Griff 15 schließt im eingeschobenen Zustand mit dem Mittelteil 3 bzw. mit der Frontseite ab. Am Übergang des Griffes 15 zum restlichen Gehäuse 7 ist ein Absatz 16 vorgesehen, ein entsprechender Absatz 17 ist gegenüberliegend seitlich angeformt. Diese Absätze 16, 17 dienen als Anschlag für den Schubblock 6 im eingeschobenen Zustand.

In Fig. 1 ist die Baugruppenanordnung 1 im nicht abgedeckten Zustand dargestellt. Um die Frontseite der Baugruppenanordnung abzudecken und dieser somit eine optisch ansprechende Form zu verleihen, sind nicht dargestellte Klappen oder Deckel vorgesehen, die um die Schwenkpunkte 18 herum schwenkbar sind. Im geschlossenen Zustand der Klappen schließen diese ebenso wie die vorderen Enden der Griffe 15, die auch bei geschlossenen Klappen sichtbar sind, mit dem Mittelteil 3 ab, so daß sich eine durchgehende vordere Fläche ergibt. Hinter den Klappen werden neben den Griffen 15 Kabelkanäle gebildet und die anwenderseitigen Leitungen mit Steckern werden von unten und oben zu den entsprechenden Steckteilen der Leiterplatten der Schubblöcke 6 geführt. Damit die Schubblöcke 6 im geschlossenen Zustand der Klappen festgelegt sind, sind seitlich an den Griffen 15 der Schubblöcke 6 Arretiernasen 19 angeformt, wobei die Klappen im geschlossenen Zustand gegen die Arretiernasen 19 drücken, so daß sich die Schubblöcke 6 auch bei Vibrationen oder dergleichen nicht lösen können und eine sichere elektrische Verbindung zwischen den Leiterplatten mit den spezifischen Schaltungen und der Leiterplatte mit der gemeinsamen Schaltung über die Steckverbindungen gewährleistet ist.

Die Gehäuse 7 bzw. die Griffe 15 der Schubblöcke 6 weisen unterschiedliche Farben entsprechend den Funktionen der Schubblöcke 6 auf, beispielsweise wird zwischen Eingangs- und Ausgangsblöcken und Sonderblöcken in der Farbe unterschieden. Da die Griffe 15 auch bei geschlossener Frontseite sichtbar sind, kann aufgrund der unterschiedlichen Farben eine schnelle Unterscheidung der Schubblöcke 6 getroffen werden.

Zusammenfassend ist zu sagen, daß durch Aufteilung der analogen Eingangs- und/oder Ausgangsschaltungen in eine gemeinsame für alle Eingänge und Ausgänge verwendbare Schaltung auf einer Grundplatine und mehrere den einzelnen Ein- und/oder Ausgängen zugeordnete Schaltungen die Schaffung von sogenannten Untermodulen möglich ist, die analog zu den Baugruppen aufgebaut sind, d.h. die gemeinsame Schaltung auf der Grundplatine ist über einen Bus und entsprechenden Anschlußklemmen mit der jeweiligen Schaltung in der als Schubblock ausgebildeten Baugruppe verbunden.

## Patentansprüche

1. Baugruppenanordnung für eine aus mehreren auf einem Träger angeordneten Baugruppen bestehende Steuerung, insbesondere zur Aufnahme von analogen Eingängen und/oder Ausgängen, mit einem Gehäuse (2), in dem mehrere übereinander angeordnete Führungen (5) zur Aufnahme von Schubblöcken (6) vorgesehen sind, denen jeweils ein Eingang oder Ausgang zugeordnet ist und die von der Frontseite her in die Führungen (5) des Gehäuses (2) einschiebbar sind, wobei in dem Gehäuse (2) eine Leiterplatte angeordnet ist, auf der eine für alle Eingänge und/oder Ausgänge gemeinsam verwendbare Schaltung aufgenommen ist und jeder Schubblock (6) als Unterbaugruppe ausgebildet ist und eine Leiterplatte mit einer für den jeweiligen Eingang oder Ausgang spezifischen Schaltung aufweist, und wobei auf der Leiterplatte mit der gemeinsam verwendbaren Schaltung und auf den Leiterplatten mit den spezifischen Schaltungen Teile von Steckverbindungen angeordnet sind, die im eingeschobenen Zustand der Schubblöcke (6) die allgemein verwendbare Schaltung mit den spezifischen Schaltungen verbinden, **dadurch gekennzeichnet,** daß jeder Schubblok ein Schubgehäuse (7) aufweist, das eine vordere Stützwand (13) mit Ausnehmungen (14) aufweist, auf der sich die mit einer vorderen Steckanordnung versehene Leiterplatte mit der spezifischen Schaltung abstützt, wobei die Steckanordnung von der Frontseite her mit einem Stecker zu einer weiteren Steckverbindung verbindbar ist und wobei die Stützwand (13) mit den Ausnehmungen (14) bzw. Vorsprüngen zur Arretierung der weiteren Steckverbindung dient.

2. Baugruppenanordnung nach Anspruch 1, dadurch gekennzeichnet, daß das Schubgehäuse (7) jedes Schubblockes (6) aus zwei Teilen (8, 9) besteht, die kraft- und/oder formschlüssig miteinander verbunden sind.

3. Baugruppenanordnung nach Anspruch 1 und 2, dadurch gekennzeichnet, daß das Schubgehäuse (7) des Schubblockes (6) eine mit einem Schlitz (10) versehene Vorderwand (11) und/oder eine Rückwand mit entsprechendem Schlitz aufweist, wobei die Leiterplatte mit der spezifischen Schaltung den Schlitz (10) durchgreift.

4. Baugruppenanordnung nach Anspruch 3, dadurch gekennzeichnet, daß in den Schlitz (10) Arretiernasen (12) hineinragen, die zur Festlegung der Leiterplatte mit der spezifischen Schaltung dienen.

5. Baugruppenanordnung nach einem der Ansprüche 1 bis 4, dadurch gekennzeichnet, daß das Schubgehäuse jedes Schubblocks einen Griff (15) zum Einschieben bzw. Herausziehen des Schubblocks (6) aufweist.

6. Baugruppenanordnung nach Anspruch 5, dadurch gekennzeichnet, daß der Griff (15) sich seitlich in Schubrichtung nach vorn erstreckt.

7. Baugruppenanordnung nach Anspruch 1 oder 6, dadurch gekennzeichnet, daß seitlich am vorderen Ende des Griffes (15) eine Anschlagnase (19) angeordnet ist, die im geschlossenen Zustand gegen eine die Frontseite abdeckende Klappe drückt und den Schubblock (6) festlegt.

8. Baugruppenanordnung nach einem der Ansprüche von 1 bis 7, dadurch gekennzeichnet, daß mindestens ein Anschlag (16, 17) vorgesehen ist, der die Einschubtiefe des Schubblockes (6) festlegt.

9. Baugruppenanordnung nach einem der Ansprüche von 7 und 8, dadurch gekennzeichnet, daß bei geschlossener Klappe das Ende des Griffes (15) seitlich neben der Klappe liegt und mit der Frontseite, d.h. mit der Klappe abschließt.

## Claims

1. Assembly arrangement for a control unit formed of several assemblies arranged on a support, in particular for the location of analog inputs and/or outputs, with a housing (2), in which several guide mechanisms (5) arranged one on top of the other are provided for locating push-in blocks (6), to which one input or output is assigned respectively and which can be pushed from the front into the guide mechanisms (5) of the housing (2), a printed circuit board being arranged in the housing (2) on which board a circuit that can be used jointly for all inputs and/or outputs is located and each push-in block (6) being designed as a sub-assembly and a printed circuit board having a circuit specific to the respective input or output, and parts of plug connectors being arranged on the printed circuit board with the circuit that can be used jointly and on the printed circuit boards with the specific circuits which, when the push-in blocks (6) are pushed-in, connect the circuit that can be used jointly with the specific circuits, **characterised in that** each push-in block has a push-in housing (7) that has a front support wall (13) with recesses (14), on which wall the printed circuit board provided with a front plug-in arrangement is supported with the specific circuit, the plug-in arrangement being capable of being connected from the front with a plug to a further plug-in connection and the support wall (13) with the recesses (14) or projections serving to block the additional plug-in connection.

2. Assembly arrangement according to claim 1 characterised in that the push-in housing (7) of each push-in block (6) comprises two parts (8, 9) that are connected to one another non-positively or positively.

3. Assembly arrangement according to claim 1 and 2 characterised in that the push-in housing (7) of the push-in blocks (6) has a front wall (11) provided with a slot (10) and/or a rear wall with corresponding slot, the printed circuit board engaged with the specific circuit through the slot (10).

4. Assembly arrangement according to claim 3 characterised in that stop noses, which serve to locate the printed circuit board with the specific circuit, project (12) into the slot (10).

5. Assembly arrangement according to one of the claims 1 to 4 characterised in that the push-in housing of each push-in block has a handle (15) for pushing-in or withdrawing the push-in block (6).

6. Assembly arrangement according to claim 5 characterised in that the handle (15) extends laterally and forwards in the push-in direction.

7. Assembly arrangement according to claim 1 or 6 characterised in that a stop nose (19) is arranged laterally on the front end of the handle (15) which nose in the closed position pushes against a flap which covers the front and locates the push-in block (6).

8. Assembly arrangement according to one of the claims 1 to 7 characterised in that at least one stop (16, 17) is provided which locates the push-in depth of the push-in block (6).

9. Assembly arrangement according to one of the claims 7 and 8 characterised in that when the flap is closed the end of the handle (15) is located laterally next to the flap and closes with the front, i.e. with the flap.

## Revendications

1. Unité de commande composée de plusieurs modules arrangés les uns à côté des autres sur un support, en particulier pour la mise en place d'entrées et/ou de sorties analogiques, comportant un boîtier (2) dans lequel plusieurs guidages (5) disposés les uns au-dessus des autres pour la mise en place de blocs tiroirs (6) auxquels est respectivement chaque fois adjoint une entrée ou une sortie et qui peuvent être introduits à partir de la face frontale dans lesdits guidages (5) du boîtier (2), une carte imprimée étant placée dans le boîtier (2) sur laquelle est disposé tout te circuit commun utilisable par toutes les entrées et/ou toutes les sorties et chaque bloc tiroir (6) étant constitué comme sous-module et présentant une carte imprimée avec un circuit spécifique pour ladite entrée ou ladite sortie et des pièces de liaisons à enfichage étant disposées à la fois sur la carte à circuit imprimé portant le circuit utilisable en commun et sur les cartes à circuit imprimé portant les circuits spécifiques pour relier en position engagée des blocs-tiroirs (6), le circuit utilisable en commun avec tes circuits spécifiques, caractérisée en ce que chaque bloc tiroir (6) présente un boîtier tiroir (7) qui possède une paroi d'appui frontale (13) avec des saillies (14) sur lesquelles la carte à circuit imprimé avec le circuit spécifique prend appui avec un dispositif frontal d'enfichage qui sort de cette face frontale pour être relié avec une fiche d'une autre liaion enfichable, la paroi d'appui 13 avec les saillies (14) ou des butées servant au blocage de cette carte de liaison enfichable.

2. Unité de commande suivant la revendication 1, caractérisée en ce que le boîtier-tiroir (7) de chaque bloc tiroir (6) est constitué par deux parties (8, 9) qui sont reliées entre elles par adhérence et/ou par assemblage.

3. Unité de commande suivant les revendications 1 et 2, caractérisée en ce que le boîtier-tiroir (7) du bloc tiroir (6) présente une paroi avant (11) pourvue d'une fente (10) et/ou une paroi arrière avec une fente analogue, la plaque de circuit imprimé portant le circuit spécifique traversant ladite fente (10).

4. Unité de commande suivant la revendication 3, caractérisée en ce que des ergots d'arrêt (12) pénètrent dans la fente (10) pour servir de retenue à la plaque portant le circuit imprimé spécifique.

5. Unité de commande selon l'une quelconque des revendications 1 à 4, caractérisèe en ce que le boîtier (7) de chaque bloc-tiroir (6) présente une prise (15) pour l'introduction ou l'extraction du bloc tiroir (6).

6. Unité de commande selon la revendication 5, caractérisée en ce que la prise (15) s'étend latéralement vers l'avant en direction du coulissement d'extraction.

7. Unité de commande selon la revendication 1 ou 6, caractérisée en ce que latéralement et à l'extrémité avant de la prise (15) est disposé un ergot d'arrêt (19) qui prend appui en position fermée contre un volet recouvrant la face frontale et immobilise ainsi ledit bloc tiroir (6).

8. Unité de commande selon l'une quelconque des revendications 1 à 7, caractérisée en ce qu'il est prévu au moins un talon (16, 17) qui arrête en profondeur l'enfoncement du bloc-tiroir (6).

9. Unité de commande selon l'une des revendications 7 ou 8, caractérisée en ce que l'extrémité de la prise (15) est disposée à côté du volet de fermeture lorsque celui-ci est fermé et qu'il affleure la face frontale c'est-à-dire ledit volet de fermeture en position fermée.
